# EUROPEAN PATENT APPLICATION

(11) **EP 4 414 649 A1**
(43) Date of publication of application: **14.08.2024**
(21) Application number: 24155979.8
(22) Date of filing: 06.02.2024
(51) Int. Cl.: F28D 7/16, F28F 1/12

(54) **HEAT EXCHANGER AND ELECTRONIC DEVICE**

(30) Priority: 08.02.2023 CN 202320249546 U
(71) Applicant: Sungrow Power Supply Co., Ltd., Hefei, Anhui 230088 (CN)
(72) Inventor: WANG, Xiaohu, Hefei, 230088 (CN); SHU, Wentao, Hefei, 230088 (CN); Hao, ZHENG, Hefei, 230088 (CN)
(74) Representative: Zacco Norway AS

(57) **Abstract**

A heat exchanger includes a heat exchange core arranged inside the housing, and a side of the housing is provided with an air vent. The heat exchanger is provided with a communication channel in communication with the air vent. The communication channel is located inside the housing, and is located at a side in the housing opposite to the air vent. In the heat exchanger, the air vent is in communication with the communication channel inside the housing, and the communication channel is located at the side in the housing opposite to the air vent, such that the internal space of the housing is fully utilized. Compared to the prior art, the overall size of the heat exchanger is reduced, and the cost for the heat exchanger is reduced.

## Description

### FIELD

The present application relates to the technical field of heat dissipation of a power electronic device, and in particular to a heat exchanger and an electronic device.

### BACKGROUND

At present, the power of a power converter or other electronic devices is becoming larger and larger, while a casing (an enclosure or a cabinet) is becoming more and more compact or even smaller, which causes the heat generation of the power electronic device to be increasing. An existing heat exchanger is of a relatively large overall size and low heat exchange efficiency, which cannot satisfy the heat dissipation requirement of the above electronic device.

In summary, an urgent problem to be solved by those skilled in the art is how to design a heat exchanger which improves the heat dissipation efficiency while reduces the size.

### SUMMARY

In view of this, an object of the present application is to provide a heat exchanger and an electronic device, which improves the heat dissipation efficiency while reduces the size.

To achieve the above object, the following technical solutions are provided according to the present application.

A heat exchanger includes a housing, and a heat exchange core arranged inside the housing. A side of the housing is provided with an air vent, the heat exchanger is provided with a communication channel in communication with the air vent. The communication channel is located inside the housing, and the communication channel is located at a side in the housing opposite to the air vent.

In an embodiment, the communication channel includes a first communication channel, and a gap is provided between an end of the heat exchange core away from the air vent and the housing, and the gap forms the first communication channel.

In an embodiment, the heat exchanger further includes a first heat exchange channel located inside the housing, and the first heat exchange channel includes at least one inlet channel and at least one outlet channel, both of which are arranged in the heat exchange core. An inlet of the inlet channel and an outlet of the outlet channel are both in communication with the air vent, and the first communication channel is in communication with an outlet of the inlet channel and an inlet of the outlet channel.

In an embodiment, in the first heat exchange channel, a channel wall of the inlet channel is isolated from a channel wall of the outlet channel adjacent thereto.

In an embodiment, at least two inlet channels are provided, and at least one second opening is provided between at least two adjacent inlet channels, and the second opening is in communication with the inlet channels at both sides thereof;
and/or, at least two outlet channels are provided, and at least one third opening is provided between at least two adjacent outlet channels, and the third opening is in communication with the outlet channels at both sides thereof.

In an embodiment, in the first heat exchange channel, the inlet channel is isolated from the outlet channel adjacent thereto by a partition plate, and the partition plate is in a sealed connection with the housing, and the partition plate is configured to extend from the air vent to the first communication channel.

In an embodiment, at least two inlet channels are provided, and channel walls of any two adjacent inlet channels are isolated; and at least two outlet channels are provided, and channel walls of any two adjacent outlet channels are isolated.

In an embodiment, the communication channel further includes a second communication channel, and the inlet channel and the outlet channel are both sub-channels. In the first heat exchange channel, at least one first opening is provided between two adjacent sub-channels. The first opening is located at an end of the sub-channel away from the air vent, and the first opening is configured to communicate the sub-channels at both sides thereof to form the second communication channel.

In an embodiment, the communication channel further includes the second communication channel, and the second communication channel is arranged in the heat exchange core, and a communication direction of the first communication channel is the same as a communication direction of the second communication channel.

In an embodiment, the communication channel further includes a second communication channel. The second communication channel is arranged in the heat exchange core, and the end of the heat exchange core away from the air vent is in a sealed connection with the housing.

In an embodiment, the heat exchanger further includes the first heat exchange channel located inside the housing, and
the first heat exchange channel includes the inlet channel and the outlet channel, and the inlet of the inlet channel and the outlet of the outlet channel are both in communication with the air vent;
the second communication channel is in communication with the outlet of the inlet channel and the inlet of the outlet channel; and
the inlet channel and the outlet channel are both sub-channels; in the first heat exchange channel, at least one first opening is provided between two adjacent sub-channels, and the first opening is located at the end of the sub-channel away from the air vent, and the first opening is in communication with the sub-channels at both sides thereof to form the second communication channel.

In an embodiment, the inlet of the inlet channel and the outlet of the outlet channel are arranged one after another along a width direction or a length direction of the air vent;
and/or, the inlet channel and the outlet channel are both straight channels.

In an embodiment, the heat exchanger further includes a second heat exchange channel, which is able to exchange heat with the first heat exchange channel, the housing is provided with an air inlet and an air outlet, and the air inlet, the second heat exchange channel and the air outlet are communicated one after another.

In an embodiment, the air inlet and the air outlet are located at two opposite sides of the housing, and the air inlet and the air outlet are located at the same side of the air vent.

In an embodiment, the heat exchange core includes one layer of heat exchange tube, and a first gap is provided between at least one side of the one layer of the heat exchange tube and the housing; or the heat exchange core includes at least two layers of the heat exchange tube, and the first gap is provided between two adjacent layers of the heat exchange tube, and
each layer of the heat exchange tube includes at least one tube, a tube cavity of the tube is the second heat exchange channel, and a heat exchange member is arranged in the first gap to form the inlet channel and the outlet channel.

In an embodiment, the heat exchange core includes one layer of heat exchange tube, and the first gap is provided between at least one side of the one layer of the heat exchange tube and the housing; or the heat exchange core includes at least two layers of the heat exchange tube, and the first gap is provided between two adjacent layers of the heat exchange tube, and
the first gap is the second heat exchange channel;
each layer of the heat exchange tube includes one tube, and at least two tube cavities of the tube are provided to form the inlet channel and the outlet channel; or each layer of the heat exchange tube includes at least two tubes, and in each layer of the heat exchange tube, a tube cavity of at least one tube forms the inlet channel, and a tube cavity of at least one tube forms the outlet channel.

In an embodiment, an end of the heat exchange tube extends into the air inlet, the other end of the heat exchange tube extends into the air outlet, and the heat exchange tube is in a fixed connection with the housing.

In an embodiment, the heat exchange member is arranged in the first gap. An end of the heat exchange member is configured to extend into the air inlet, the other end of the heat exchange member is configured to extend into the air outlet, and the heat exchange member is in a fixed connection with the housing.

In an embodiment, the housing is an integrated structure; and/or, a flange structure is arranged on the housing at a periphery of the air vent, and the flange structure is in a sealed connection with a cavity of an electric device.

Based on the heat exchanger provided above, an electric device is further provided according to the present application. The electric device includes an enclosure, and at least one heat exchanger according to any of the solutions above, and
the enclosure includes a first cavity and a second cavity, a heat generating device is arranged inside the first cavity, and the first cavity is sealed;
the heat exchanger is arranged inside the first cavity, and the air vent of the heat exchanger is in communication with the second cavity; or, the heat exchanger is arranged inside the second cavity, and the air vent of the heat exchanger is in communication with the first cavity.

In an embodiment, the electric device further includes:
a first partition, the first partition is arranged in the first cavity or the second cavity which is in communication with the air vent, and the first partition is located at the air vent, and separates an inlet portion and an outlet portion of the air vent apart; and
and/or a second partition, the second partition is arranged inside the enclosure, and the second partition divided an inner cavity of the enclosure into the first cavity and the second cavity.

In an embodiment, the electric device further includes at least one first fan, and/or at least one second fan, where the first fan is configured to drive the airflow in the first cavity, and the second fan is configured to drive the airflow in the second cavity.

In the heat exchanger according to the present application, the air vent is in communication with the communication channel inside the housing, and the communication channel is located at the side in the housing opposite to the air vent, such that the internal space of the housing is fully utilized. Compared to the prior art, the overall size of the heat exchanger is effectively reduced, and the cost for the heat exchanger is reduced. Moreover, on the premise that the heat exchanger according to the present application is of the same size as the heat exchanger in the prior art, the heat exchange efficiency of the heat exchanger is improved. Therefore, the above heat exchanger improves the heat dissipation efficiency while reducing the size.

### BRIEF DESCRIPTION OF THE DRAWINGS

For more clearly illustrating embodiments of the present application or the technical solutions in the conventional technology, drawings referred to describe the embodiments or the conventional technology will be briefly described hereinafter. Apparently, the drawings in the following description are only some examples of the present application, and for those skilled in the art, other drawings may be obtained based on these drawings without any creative efforts.
FIG. 1 is an axonometric view showing a heat exchanger according to a first embodiment of the present application;
FIG. 2 is a side view showing the heat exchanger in FIG. 1;
FIG. 3 is a schematic view showing the structure of a housing in FIG. 1;
FIG. 4 is a schematic view showing the structure of a heat exchange core in FIG. 1;
FIG. 5 is a schematic view showing the structure of the heat exchanger in FIG. 1 arranged in a first cavity;
FIG. 6 is a side view showing the structure in FIG. 5;
FIG. 7 is a schematic view showing the structure of the heat exchanger in FIG. 1 arranged in a second cavity;
FIG. 8 is a side view showing the structure in FIG. 7;
FIG. 9 is an axonometric view showing a heat exchanger according to a second embodiment of the present application;
FIG. 10 is a side view showing the heat exchanger in FIG. 9;
FIG. 11 is a schematic view showing the structure of a housing in FIG. 9;
FIG. 12 is a schematic view showing the structure of a heat exchange core in FIG. 9;
FIG. 13 is an axonometric view showing a heat exchanger according to a third embodiment of the present application;
FIG. 14 is a top view showing the heat exchanger in FIG. 13;
FIG. 15 is a side view showing the heat exchanger in FIG. 13;
FIG. 16 is a schematic view showing the structure of a partition in FIG. 13;
FIG. 17 is a schematic view showing the structure of a heat exchange member in FIG. 13;
FIG. 18 is an axonometric view showing a heat exchange member of a heat exchanger according to a fourth embodiment of the present application;
FIG. 19 is an axonometric view showing a heat exchange member of a heat exchanger according to a fifth embodiment of the present application;
FIG. 20 is a sectional view taken along line A-A in FIG. 19;
FIG. 21 is a sectional view taken along line B-B in FIG. 19;
FIG. 22 is an axonometric view showing the heat exchange tube in FIG. 21;
FIG. 23 is an axonometric view showing a heat exchanger according to a sixth embodiment of the present application;
FIG. 24 is a side view showing the heat exchanger in FIG. 23;
FIG. 25 is a schematic view showing the structure of a housing in FIG. 23;
FIG. 26 is a schematic view showing the structure of a heat exchange core in FIG. 23;
FIG. 27 is a schematic view showing the structure of the heat exchanger in FIG. 23 arranged in a second cavity;
FIG. 28 is a side view showing the structure in FIG. 27;
FIG. 29 is an axonometric view showing a heat exchanger according to a seventh embodiment of the present application;
FIG. 30 is a side view showing the heat exchanger in FIG. 29;
FIG. 31 is a schematic view showing the structure of a housing in FIG. 29; and
FIG. 32 is a schematic view showing the structure of a heat exchange core in FIG. 29.

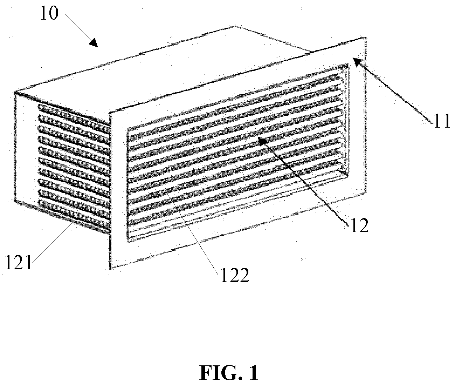

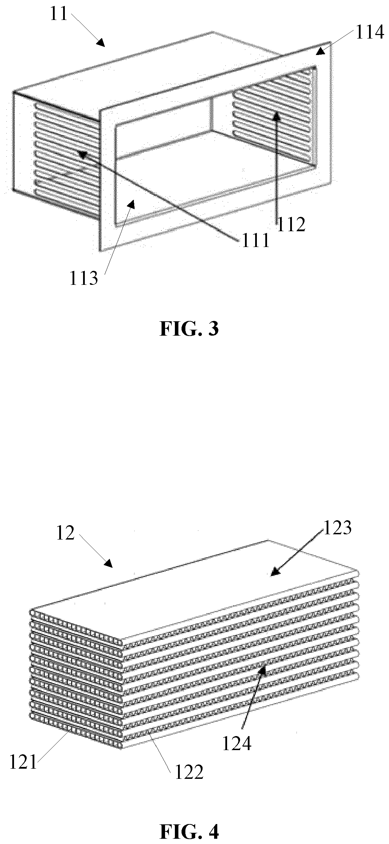

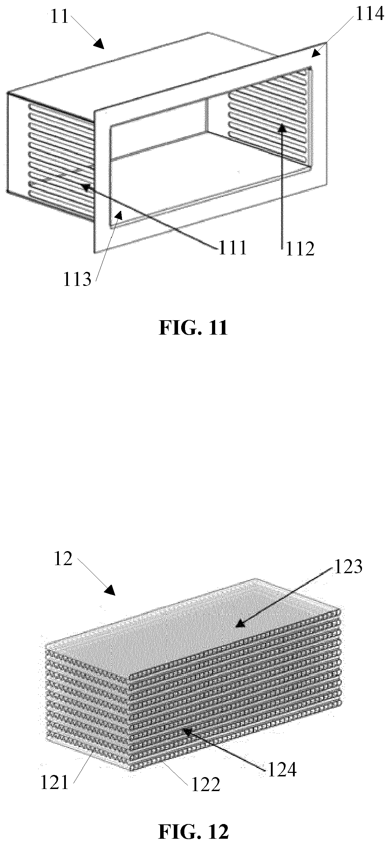

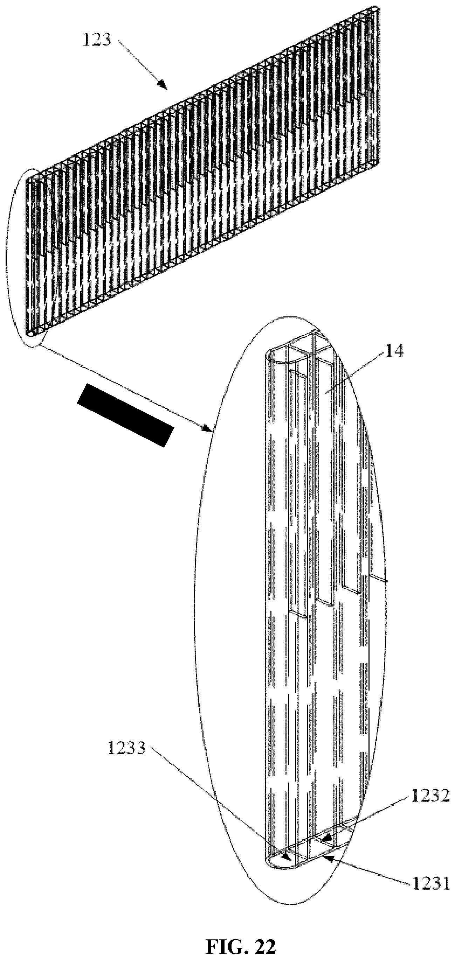

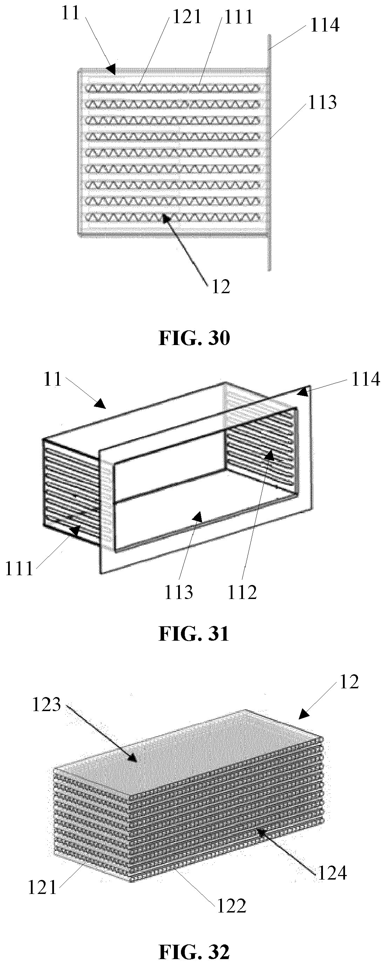

**Reference numerals in FIGS. 1 to 32:**

| | | | |
|---|---|---|---|
| 10 | heat exchanger, | 20 | enclosure, |
| 30 | first fan, | 40 | second fan, |
| 50 | first partition, | 60 | second partition, |
| 11 | housing, | 12 | heat exchange core, |
| 13 | first communication channel, | 14 | first opening, |
| 111 | air inlet, | 112 | air outlet, |
| 113 | air vent, | 114 | flange structure, |
| 121 | second heat exchange channel, | 122 | first heat exchange channel, |
| 123 | heat exchange tube, | 124 | heat exchange member, |
| 125 | partition plate, | 1231 | tube body, |
| 1232 | separator, | 1233 | tube cavity, |
| 1241 | inclined plate, | 1242 | first through hole, |
| 1251 | mounting hole, | 21 | first cavity, |
| 22 | second cavity. | | |

### DETAILED DESCRIPTION OF THE EMBODIMENTS

Technical solutions according to the embodiments of the present application will be described clearly and completely as follows in conjunction with the accompany drawings in the embodiments of the present application. It is obvious that the described embodiments are only a part of the embodiments according to the present application, rather than all of the embodiments. All the other embodiments obtained by those skilled in the art based on the embodiments in the present application without any creative work belong to the scope of protection of the present application.

An existing heat exchanger mainly includes a main body and connection tubes arranged at two ends of the main body, and one connection tube has an air inlet, the other connection tube has an air outlet, and both the air inlet and the air outlet are in communication with an internal cavity of the main body. The main body includes multiple heat exchange tubes, an internal cavity of which forms a first heat exchange channel, and a gap between two adjacent heat exchange tubes forms a second heat exchange channel. Hot air enters the first heat exchange channel of the main body through the air inlet, and is discharged through the air outlet, while cool air flows through the second heat exchange channel of the main body, thereby implementing heat exchange between the hot air and the cool air.

In the above heat exchanger, two connection tubes are required to be arranged separately to form the air inlet and the air outlet, resulting in a large size of the heat exchanger. Furthermore, the cool air and the hot air exchange heat only through the main body, leading to a low heat exchange efficiency.

In addition, if the first heat exchange channel and the second heat exchange channel are provided in the connection tubes for heat exchange between the cool air and the hot air, the first heat exchange channel is in a bent shape, such that the process cost is high.

Based on the above problems, a heat exchanger and an electronic device are provided according to the present application.

As shown in FIGS. 1 to 4, 9 to 15, 23 to 26, and 29 to 32, a heat exchanger 10 provided by the present application includes a housing 11, and a heat exchange core 12 arranged inside the housing 11.

In the above heat exchanger 10, a side of the housing 11 is provided with an air vent 113. The heat exchanger 10 includes a communication channel in communication with the air vent 113, and the communication channel is located inside the housing 11, and is located at a side in the housing 11 opposite to the air vent 113. It may be appreciated that, the communication channel is located at a side in the housing 11 away from the air vent 113.

The above air vent 113 is in communication with a cavity of an electric device to cool the cavity. Certainly, the air vent 113 may be in communication with other places, which is not limited in the present embodiment.

In the heat exchanger 10 according to the present embodiment, the air vent 113 is in communication with the communication channel inside the housing 11, and the communication channel is located at the side in the housing 11 opposite to the air vent 113, such that an internal space of the housing 11 can be fully utilized. Compared to the heat exchanger in the prior art, two additional connection tubes are not needed, so as to effectively reduce the overall size of the heat exchanger 10 and reduce the cost for the heat exchanger 10. Moreover, on the premise that the above heat exchanger 10 is of the same size as the heat exchanger in the prior art, the heat exchange efficiency of the heat exchanger 10 is improved. Therefore, the heat exchanger 10 according to the present embodiment improves the heat dissipation efficiency while reducing the size.

The heat exchanger 10 according to the present embodiment is applicable to environment of a relatively high temperature. When the ambient temperature is relatively high, an internal temperature of a cavity with heat to be dissipated can be kept stable, thereby ensuring the proper functioning of a device inside the cavity.

Multiple kinds of structures can be applied to the above communication channel. In some embodiments, the communication channel includes a first communication channel 13, and a gap is provided between an end of the heat exchange core 12 away from the air vent 113 and the housing 11, and the gap forms the first communication channel 13. It may be appreciated that, the first communication channel 13 is located between the heat exchange core 12 and the housing 11. In this case, the heat exchange core 12 does not occupy the whole internal cavity of the housing 11.

In some embodiments, the communication channel includes a second communication channel, the second communication channel is arranged in the heat exchange core 12, and the end of the heat exchange core 12 away from the air vent 113 is in a sealed connection with the housing 11. It may be appreciated that, the second communication channel is arranged at the end of the heat exchange core 12 away from the air vent 113. In this case, the heat exchange core 12 may occupy the whole internal cavity of the housing 11, such that when the heat exchange core 12 is the same, the overall size of the housing 11 is reduced; and when the size of the housing 11 is the same, the heat exchange efficiency and effect are improved. Moreover, since the second communication channel is arranged in the heat exchange core 12, the heat exchange path is lengthened, and the heat exchange effect is enhanced.

In other embodiments, the communication channel includes the first communication channel 13 and the second communication channel, and the gap is provided between the end of the heat exchange core 12 away from the air vent 113 and the housing 11, and the gap forms the first communication channel 13. The second communication channel is arranged in the heat exchange core 12. In this case, a communication direction of the first communication channel 13 is the same as a communication direction of the second communication channel. In this way, one part of the air can flow through the first communication channel 13, while the other part of the air can flow through the second communication channel. Since the second communication channel is arranged in the heat exchange core 12, the heat exchange path is lengthened, and the heat exchange effect is enhanced.

Certainly, the above communication channel may be formed in other manners, which is not limited to the above descriptions.

In the above heat exchanger 10, to facilitate the communication between the communication channel and the air vent 113, the above heat exchanger 10 further includes a first heat exchange channel 122 located inside the housing 11, and the communication channel is in communication with the air vent 113 through the first heat exchange channel 122. It may be appreciated that, if the communication channel includes the first communication channel 13, the first communication channel 13 is in communication with the air vent 113 through the first heat exchange channel 122. If the communication channel includes the second communication channel, the second communication channel is in communication with the air vent 113 through the first heat exchange channel 122. If the communication channel includes the first communication channel 13 and the second communication channel, the first communication channel 13 is in communication with the air vent 113 through the first heat exchange channel 122, and the second communication channel is in communication with the air vent 113 through the first heat exchange channel 122.

In the above heat exchanger 10, an inlet and an outlet of the first heat exchange channel 122 are both in communication with the air vent 113. In order to prevent mutual interference between an airflow into the first heat exchange channel 122 and an airflow out of the first heat exchange channel 122, the first heat exchange channel 122 includes an inlet channel and an outlet channel, both of which are arranged in the heat exchange core 12, and an inlet of the inlet channel and an outlet of the outlet channel are both in communication with the air vent 113. It may be appreciated that, the inlet of the inlet channel is the inlet of the first heat exchange channel 122, and the outlet of the outlet channel is the outlet of the first heat exchange channel 122.

The specific structures of the above inlet channel and outlet channel are designed according to actual situations, which is not limited in the present embodiment.

If the communication channel includes the first communication channel 13, the first communication channel 13 communicates an outlet of the inlet channel with an inlet of the outlet channel. If the communication channel includes the second communication channel, the second communication channel communicates the outlet of the inlet channel with the inlet of the outlet channel. If the communication channel includes the first communication channel 13 and the second communication channel, the first communication channel 13 communicates the outlet of the inlet channel with the inlet of the outlet channel, and the second communication channel communicates the outlet of the inlet channel with the inlet of the outlet channel.

At least one air vent 113 is provided. To simplify the structure and reduce the manufacturing cost, one air vent 113 is provided. That is, one portion of the air vent 113, the inlet channel, the communication channel, the outlet channel and the other portion of the air vent 113 are communicated in sequence.

In the above structure, alternatively, the air vent 113 is divided into several air sub-vents by providing a partition. One portion of the air vent 113 forms at least one air sub-vent, and the other portion of the air vent 113 forms at least one air sub-vent.

In a case that at least two air vents 113 are provided, some of the air vents 113, the inlet channel, the communication channel, the outlet channel and others of the air vents 113 are communicated in sequence.

At least one inlet channel and at least one outlet channel are provided. If not less than two inlet channels are provided, and one outlet channel is provided, outlets of two adjacent inlet channels are communicated through the communication channel, and the inlet of the outlet channel is communicated with an outlet of an inlet channel adjacent thereto through the communication channel. If not less than two outlet channels are provided, and one inlet channel is provided, inlets of two adjacent outlet channels are communicated through the communication channel, and the outlet of the inlet channel is communicated with an outlet of an outlet channel adjacent thereto through the communication channel. If not less than two inlet channels and not less than two outlet channels are provided, outlets of two adjacent inlet channels are communicated through the communication channel, inlets of two adjacent outlet channels are communicated through the communication channel, and an inlet of an outlet channel is communicated with an outlet of an inlet channel adjacent thereto through the communication channel.

In some embodiments, the communication channel includes the first communication channel 13. In the first heat exchange channel 122, a channel wall of the inlet channel is isolated from a channel wall of the outlet channel adjacent thereto, i.e. the channel wall of the inlet channel is not in communication with the channel wall of the outlet channel adjacent thereto.

The above structure is achieved by not providing a hole on the channel wall of the inlet channel and nor on the channel wall of the outlet channel adjacent thereto, or by providing a partition plate 125. In order to simplify the structure and facilitate producing and manufacturing, in the first heat exchange channel 122, the inlet channel is isolated from the outlet channel adjacent thereto by the partition plate 125. The partition plate 125 is in a sealed connection with the housing 11, and extends from the air vent 113 to the first communication channel 13. It should be noted that, a top end of the partition plate 125 is in a sealed connection with a top end of the housing 11, and a bottom end of the partition plate 125 is in a sealed connection with a bottom end of the housing 11.

In a case that the channel wall of the inlet channel is isolated from the channel wall of the outlet channel adjacent thereto, at least two inlet channels are provided, and channel walls of at least two adjacent inlet channels are communicated; and/or, at least two outlet channels are provided, and the channel walls of at least two adjacent outlet channels are communicated. In this way, the turbulence effect of air is enhanced, thereby improving the heat exchange effect of the whole heat exchanger 10.

To make the channel walls of at least two adjacent inlet channels in communication, at least one second opening is provided between the two adjacent inlet channels, and the second opening communicates the inlet channels at both sides thereof.

To make the channel walls of at least two adjacent outlet channels in communication, at least one third opening is provided between the two adjacent outlet channels, and the third opening communicates the outlet channels at both sides thereof.

The size and the structure of the second opening and the third opening are selected according to actual requirements, which is not limited in the present embodiment.

In actual situations, alternatively, at least two inlet channels are provided, and channel walls of any two adjacent inlet channels are isolated; at least two outlet channels are provided, and channel walls of any two adjacent outlet channels are isolated, which are not limited to the above cases.

For easy description, the inlet channel and the outlet channel are both referred to as sub-channels, that is, at least two sub-channels are provided. In some embodiments, in a case that the communication channel includes the first communication channel 13 and the second communication channel, or that the communication channel includes the second communication channel, for easily forming the second communication channel, in the above first heat exchange channel 122, at least one first opening 14 is provided between two adjacent sub-channels. The first opening 14 is located at an end of the sub-channel away from the air vent 113, and communicates the sub-channels at both sides thereof to form the second communication channel.

In some embodiments, the inlet of the inlet channel extends to the air vent 113, and the outlet of the outlet channel extends to the air vent 113. In this way, the first heat exchange channel 112 is lengthened while the size is not enlarged, such that the heat dissipation efficiency is improved.

The inlet end of the above inlet channel may extend into the air vent 113, or may not extend into the air vent 113. If the inlet end of the inlet channel does not extend into the air vent 113, the inlet end of the inlet channel directly abuts the air vent 113. The outlet end of the above outlet channel may extend into the air vent 113, or may not extend into the air vent 113. If the outlet end of the outlet channel does not extend into the air vent 113, the outlet end of the outlet channel directly abuts the air vent 113.

In the above heat exchanger 10, the air vent 113 is located at a side of the housing 11, i.e. the air vent 113 is provided on a side surface of the housing 11. The above air vent 113 may be of a rectangular shape, a square shape, a round shape or other shapes, which is selected according to actual situations.

To facilitate the flow of air in and out of the first heat exchange channel 122, on the one hand, the inlets of the inlet channels and the outlets of the outlet channels are arranged one after another along a width direction of the air vent 113; on the other hand, the inlets of the inlet channels and the outlets of the outlet channels are arranged one after another along a length direction of the air vent 113.

It should be noted that, if the air vent 113 is of a round shape, two radial directions of the round perpendicular to each other are taken as the width direction and the length direction of the air vent 113 respectively. If the air vent 113 is of a square shape, directions of two sides of the square perpendicular to each other are taken as the width direction and the length direction of the air vent 113 respectively. If the air vent 113 is of a rectangular shape, a width direction of the rectangle is taken as the width direction of the air vent 113, and a length direction of the rectangle is taken as the length direction of the air vent 113. If the air vent 113 is of another shape, the above width direction and length direction are perpendicular to each other, a direction of a straight line passing through two points on an outer profile of the air vent 113 is taken as the length direction, where the distance between the two points is maximal, and the width direction is determined based on the length direction.

In actual situations, alternatively, the inlets of the inlet channels and the outlets of the outlet channels are arranged along other directions. For example, the air vent 113 is a rectangular shape, and the inlets of the inlet channels and the outlet of the outlet channels are arranged one after another along a diagonal direction of the air vent 113.

In the above heat exchanger 10, to simplify the structure, the inlet channel and the outlet channel are both straight. In this case, the first communication channel 13 and the air vent 113 are located at two sides of the inlet channel respectively, and the first communication channel 13 and the air vent 113 are located at two sides of the outlet channel. A length direction of the first communication channel 13 is perpendicular to a length direction of the inlet channel and a length direction of the outlet channel.

In the above heat exchanger 10, the first communication channel 13, the inlet channel and the outlet channel are all straight, so as to simplify the process and reduce the cost.

Correspondingly, the second communication channel is parallel to the first communication channel, so as to simplify the process and reduce the cost.

Certainly, the above inlet channel and outlet channel may be of other shapes, which is not limited to the above embodiments.

In some embodiments, to improve the heat exchange efficiency and effect of the heat exchanger 10, the above heat exchanger further includes a second heat exchange channel 121 which can exchange heat with the first heat exchange channel 122. The housing 11 is provided with an air inlet 111 and an air outlet 112, and the air inlet 111, the second heat exchange channel 121 and the air outlet 112 are communicated in sequence.

At least one air inlet 111 and at least one air outlet 112 are provided, and at least one second heat exchange channel 121 is provided. In one aspect, one air inlet 111 and one air outlet 112 are provided to simplify the structure. In another aspect, the second heat exchange channel 121 is in one-to-one correspondence to the air inlet 111, and the second heat exchange channel 121 is in one-to-one correspondence to the air outlet 112 to facilitate the flow of air in and out.

It should be noted that, the air inlet 111 and the air outlet 112 are in communication with the same cavity, while the air vent 113 and the air inlet 111 are in communication with two different cavities respectively, and at least one of the two different cavities is a sealed cavity. In this way, the air in one cavity flows through the first heat exchange channel 122, and the air in the other cavity flows through the second heat exchange channel 121, such that the first heat exchange channel 122 and the second heat exchange channel 121 exchange heat to dissipate heat of at least one cavity.

In some embodiments, an inlet of the second heat exchange channel 121 extends to the air inlet 111, and an outlet of the second heat exchange channel 121 extends to the air outlet 112. In this way, the second heat exchange channel 121 is lengthened while the size is not enlarged, such that the heat dissipation efficiency is improved.

It may be appreciated that, the inlet end of the second heat exchange channel 121 may extend into the air inlet 111, or may not extend into the air inlet 111. If the inlet end of the second heat exchange channel 121 does not extend into the air inlet 111, the inlet end of the second heat exchange channel 121 directly abuts the air inlet 111. The outlet end of the second heat exchange channel 121 may extend into the air outlet 112, or may not extend into the air outlet 112. If the outlet end of the second heat exchange channel 121 does not extend into the air outlet 112, the outlet end of the second heat exchange channel 121 directly abuts the air outlet 112.

In the above embodiments, the air inlet 111 and the air outlet 112 are located at two opposite sides of the housing 11 respectively, and the air inlet 111 and the air outlet 112 are located at the same side of the air vent 113. In this case, the second heat exchange channel 121 is straight, and the air inlet 111 and the air outlet 112 are located at two sides of the second heat exchange channel 121 in a length direction thereof respectively. It may be appreciated that, the air vent 113 is located between the air inlet 111 and the air outlet 112. In this way, the size of the housing 11 is effectively reduced, and the air flows through the second heat exchange channel 121 along a straight line without turning in the second heat exchange channel 121, such that the smoothness of the second heat exchange channel 121 is improved, thereby improving the heat exchange efficiency and effect. Moreover, the heat exchange core 12 can be directly inserted into the housing 11 through the air vent 113, which simplifies the assembly of the heat exchange core 12 and the housing 11.

The above housing 11 is of a rectangular shape. The air inlet 111 and the air outlet 112 are located at two sides of the housing 11 in a length direction thereof respectively, and the air vent 113 is located at a side of the housing 11 in a width direction thereof, or the air vent 113 is located at a side of the housing 11 in a height direction thereof. Alternatively, the air inlet 111 and the air outlet 112 are located at two sides of the housing 11 in the width direction thereof respectively, and the air vent 113 is located at a side of the housing 11 in the length direction thereof, or the air vent 113 is located at a side of the housing 11 in the height direction thereof. Alternatively, the air inlet 111 and the air outlet 112 are located at two sides of the housing 11 in the height direction thereof respectively, and the air vent 113 is located at a side of the housing 11 in the length direction thereof, or the air vent 113 is located at a side of the housing 11 in the width direction thereof.

Certainly, the housing 11 may be of other shapes, and the air inlet 111, the air outlet 112 and the air vent 113 are arranged in other manners, which are not limited to the above present embodiments.

In the above heat exchanger 10, the specific structure of the heat exchange core 12 is designed according to actual situations, which is not limited in the present embodiments.

The above housing 11 is of an integrated structure or a separated structure. For simply mounting, the housing 11 is of an integrated structure, that is, the housing 11 is a one-piece structure.

The above housing 11 is a sheet metal part or a part of other materials, which is not limited in the present embodiment.

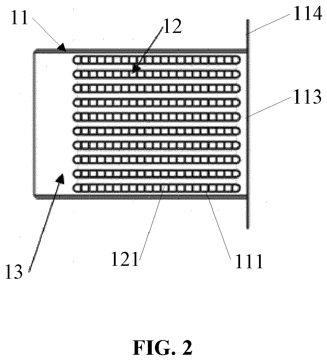

Since the air vent 113 is required to be in communication with a cavity, for easily mounting the above heat exchanger 10, the above housing 11 is provided with a flange structure 114 at a periphery of the air vent 113, and the flange structure 114 is in a sealed connection with the cavity of the electric device, as shown in FIGS. 2, 3, 10, 11, 15, 24, 25, 30 and 31. Alternatively, the above housing 11 may be in a sealed connection with the cavity of the electric device via other structures, such as a seal ring or the like, which is not limited in the present embodiment.

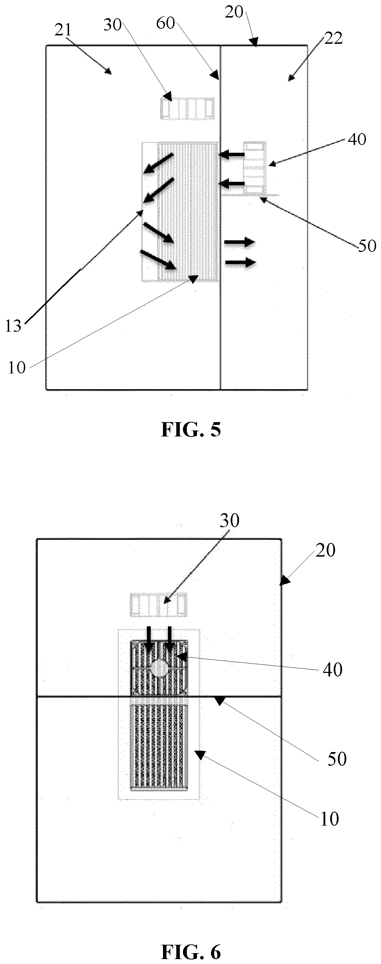

Based on the heat exchanger 10 according to the above heat exchanger 10, an electric device is further provided in the present embodiment. As shown in FIGS. 5 to 8, 27 and 28, the electric device includes an enclosure 20 and at least one heat exchanger 10 according to the above embodiments. The enclosure 20 includes a first cavity 21 and a second cavity 22, and a heat generating device is arranged inside the first cavity 21, and the first cavity 21 is sealed.

It should be noted that, the first cavity 21 is referred to as an inner cavity, and the second cavity 22 is referred to as an outer cavity. The first cavity 21 is a high protection cavity, and the second cavity 22 is a high protection cavity or a low protection cavity, and the protection level of the low protection cavity is less than the protection level of the high protection cavity.

As shown in FIG. 5, the above heat exchanger 10 is arranged inside the first cavity 21, and the air vent 113 of the heat exchanger 10 is in communication with the second cavity 22. In a case that the heat exchanger 10 includes the first heat exchange channel 122 and the second heat exchange channel 121, the first heat exchange channel 122 is in communication with the second cavity 22, and the second heat exchange channel 121 is in communication with the first cavity 21.

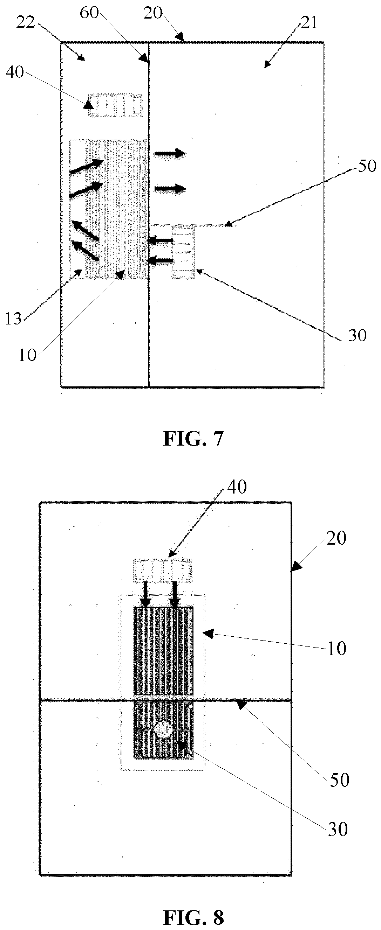

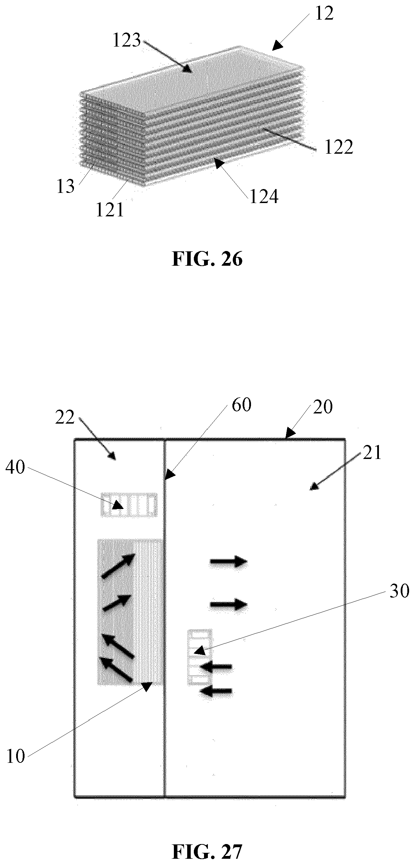

As shown in FIGS. 7 and 27, the heat exchanger 10 is arranged inside the second cavity 22, and the air vent 113 of the heat exchanger 10 is in communication with the first cavity 21. In the case that the heat exchanger 10 includes the first heat exchange channel 122 and the second heat exchange channel 121, the first heat exchange channel 122 is in communication with the first cavity 21, and the second heat exchange channel 121 is in communication with the second cavity 22.

It is known from above that, the heat exchanger 10 can be mounted either inside the first cavity 21 or inside the second cavity 22, which can be flexibly applied according to the overall arrangement of the electric device, so as to reduce the overall size and the overall cost.

Since the heat exchanger 10 provided in the above embodiments has the above technical effects, and the above electric device has the above heat exchanger 10, the above electric device also has the corresponding technical effects, which is not be described herein.

The above electric device may be a power electric device, which may be a power converter or other devices, and the types of the electric device is not limited in the present embodiment.

The inlet of the first heat exchange channel 122 is in communication with an inlet portion of the air vent 113, and the outlet of the first heat exchange channel 122 is in communication with an outlet portion of the air vent 113. That is, the inlet of the inlet channel is in communication with the inlet portion of the air vent 113, and the outlet of the outlet channel is in communication with the outlet portion of the air vent 113. Therefore, the airflow is apt to be crossed or shorted out at the air vent 113. In order to prevent that, the above electric device further includes a first partition 50, which is arranged inside the first cavity 21 or the second cavity 22 in communication with the air vent 113, and is located at the air vent 113. The inlet portion and outlet portion of the air vent 113 are distributed at both sides of the first partition 50. It may be appreciated that, the first partition 50 separates the inlet portion and outlet portion of the air vent 113.

As shown in FIG. 5, the above heat exchanger 10 is arranged inside the first cavity 21, and the first partition 50 is arranged inside the second cavity 22 in communication with the air vent 113. As shown in FIG. 7, the above heat exchanger 10 is arranged inside the second cavity 22, and the first partition 50 is arranged inside the first cavity 21 in communication with the air vent 113.

It should be noted that, the above first partition 50 may be arranged on the housing 11, or may be arranged on the enclosure 20, which is not limited in the present embodiment.

For easily forming the first cavity 21 and the second cavity 22, as shown in FIGS. 5 and 7, the above electric device further includes a second partition 60. The second partition 60 is arranged inside the enclosure 20, and separates the inner cavity of the enclosure 20 into the first cavity 21 and the second cavity 22.

To facilitate the heat exchange between air in the first cavity 21 and the second cavity 22 through the heat exchanger 10, the above electric device further includes at least one first fan 30, and/or at least one second fan 40. The first fan 30 drives the airflow in the first cavity 21, and the second fan 40 drives the airflow in the second cavity 22.

It may be appreciated that, the first heat exchange channel 122 and the second heat exchange channel 121 are both heat exchange channels. The first fan 30 drives the air in the first cavity 21 to flow through the heat exchange channel in communication with the first cavity 21, and the second fan 40 drives the air in the second cavity 22 to flow through the heat exchange channel in communication with the second cavity 22. If the second cavity 22 is in communication with external environment, the air in the second cavity 22 is the air in external environment.

In actual situations, the first fan 30 is arranged inside the first cavity 21, and the second fan 40 is arranged inside the second cavity 22.

If the heat exchanger 10 is arranged inside the second cavity 22, the second heat exchange channel 121 of the heat exchanger 10 is in communication with the second cavity 22, and the air vent 113 of the heat exchanger 10 is in communication with the first cavity 21. The first fan 30 faces the inlet portion of the air vent 113, or the first fan 30 faces the outlet portion of the air vent 113. The second fan 40 faces the inlet of the second heat exchange channel 121, or the second fan 40 faces the outlet of the second heat exchange channel 121.

It should be noted that, in an application situation where heat exchange is not very large or where the size of the heat exchanger 10 is large, an air duct is provided to make the air in the second cavity 22 flow through the second heat exchange channel 121 instead of providing the second fan 40, as long as the heat exchanged requirement is satisfied.

If the heat exchanger 10 is arranged inside the first cavity 21, the second heat exchange channel 121 of the heat exchanger 10 is in communication with the first cavity 21, and the air vent 113 of the heat exchanger 10 is in communication with the second cavity 22. The first fan 30 faces the inlet of the second heat exchange channel 121, or the first fan 30 faces the outlet of the second heat exchange channel 121. The second fan 40 faces the inlet portion of the air vent 113, or the second fan faces the outlet portion of the air vent 113.

It should be noted that, in an application situation where heat exchange is not very large or where the size of the heat exchanger 10 is large, an air duct is provided to make the air in the first cavity 21 flow through the second heat exchange channel 121 instead of providing the first fan 30, as long as the heat exchanged requirement is satisfied.

In order to describe the technical solutions provided in the present application in detail, four embodiments are provided hereinafter.

### First Embodiment

As shown in FIGS. 1 to 4, in the first embodiment, in the heat exchanger 10, the housing 11 is of a rectangular shape. The air inlet 111 is arranged at one end of the housing 11 in the length direction, and the air outlet 112 is arranged at the other end of the housing 11 in the length direction. The air vent 113 is arranged at one end of the housing 11 in the width direction. In this case, the air inlet 11 and the air outlet 112 are both located at the same side of the air vent 113, and the air vent 113 is located between the air inlet 111 and the air outlet 112.

The heat exchanger 10 includes the first communication channel 13, the first heat exchange channel 122 and the second heat exchange channel 121. The first communication channel 13, the first heat exchange channel 122 and the second heat exchange channel 121 are all located inside the housing 11. A gap is provided between the end of the heat exchange core 12 away from the air vent 113 and the housing 11, and the gap forms the first communication channel 13.

The inlet and outlet of the above first heat exchange channel 122 are both in communication with the air vent 113, and the above first heat exchange channel 122 includes the inlet channel and the outlet channel, which are both arranged in the heat exchange core 12. The inlet of the inlet channel and the outlet of the outlet channel are both in communication with the air vent 113, and the first communication channel 13 is in communication with the outlet of the inlet channel with the inlet of the outlet channel. In this case, the end in the housing 11 away from the air vent 113 is referred to as a bottom end of the housing 11, and the end of the heat exchange core 12 away from the air vent 113 is referred to as a bottom end of the heat exchange core 12. The air inlet 111 and the air outlet 112 do not extend to the bottom end of the housing 11. The first communication channel 13 is located between the bottom end of the heat exchange core 12 and the bottom end of the housing 11, and a preset distance is provided between the bottom of the housing 11, and both the air inlet 111 and the air outlet 112, to form the first communication channel 13.

The second heat exchange channel 121 is able to exchange heat with the first heat exchange channel 122. The air inlet 111 of the housing 11, the second heat exchange channel 121 and the air outlet 112 of the housing 11 are communicated in sequence.

To easily form the first heat exchange channel 122 and the second heat exchange channel 121, the above heat exchange core 12 includes one layer of heat exchange tube 123, and a first gap is provided between at least one side of the layer of the heat exchange tubes 123 and the housing 11. Or, the heat exchange core 12 includes at least two layers of the heat exchange tube 123, and the first gap is provided between two adjacent layers of the heat exchange tube 123. Each layer of the heat exchange tube 123 includes at least one heat exchange tube 123.

A tube cavity of the above heat exchange tube 123 is taken as the second heat exchange channel 121, and a heat exchange member 124 is arranged in the first gap to form the first heat exchange channel 122. In a case that the first heat exchange channel 122 includes the inlet channel and the outlet channel, the heat exchange member 124 divides the first gap into the inlet channel and the outlet channel.

It should be noted that, the heat exchange member 124 has two functions, one of which is to divide the first gap into the inlet channel and the outlet channel, the other of which is to increase the heat dissipation area, so as to achieve a quick heat dissipation, thereby the heat dissipation efficiency is improved.

To improve the heat exchange efficiency, the heat exchange tube 123 is a microchannel flat tube, or may be of other types, which is not limited in the first embodiment.

The above heat exchange member 124 is a heat exchange fin, such as a corrugated fin or other types of fins. Alternatively, the above heat exchange member 124 is a tube structure, for example, a microchannel flat tube or other types of tubes, which is not limited in the first embodiment.

For ease of mounting, one end of the heat exchange tube 123 extends into the air inlet 111, the other end of the heat exchange tube 123 extends into the air outlet 112, and the heat exchange tube 123 is in a fixed connection with the housing 11. In this case, the heat exchange member 124 is in a fixed connection with the heat exchange member 123.

Alternatively, one end of the heat exchange tube 123 does not extend into the air inlet 111, and the other end of the heat exchange tube 123 does not extend into the air outlet 112. For example, one end of the heat exchange tube 123 abuts the air inlet 111, the other end of the heat exchange tube 123 abuts the air outlet 112, which is not limited in the first embodiment.

For ease of fixing the heat exchange tube 123, the heat exchange tube 123 is connected to the housing 11 by bonding or by welding. Alternatively, the heat exchange tube 123 may be fixedly connected to the housing 11 by other means.

As shown in FIGS. 5 and 6, when the heat exchanger 10 is applied in the first embodiment to an electric device, the heat exchanger 10 is arranged inside the first cavity 21 of the enclosure 20. The second heat exchange channel 121 is in communication with the first cavity 21, and the first heat exchange channel 122 is in communication with the second cavity 22 of the enclosure 20 through the air vent 113. The first partition 50 is arranged inside the second cavity 22, and the inlet portion and outlet portion of the air vent 113 are located at both sides of the first partition 50 respectively, i.e. the first partition 50 separates the inlet portion from the outlet portion of the air vent 113. The first fan 30 inside the first cavity 21 faces the inlet of the second heat exchange channel 121, and the second fan 40 inside the second cavity 22 faces the inlet portion of the air vent 113. The hot air in the first cavity 21 flows through the second heat exchange channel 121 under the action of the first fan 30, and the cool air in the second cavity 22 flows through the first heat exchange channel 122 under the action of the second fan 40. The hot air and cool air exchange heat through the second heat exchange channel 121 and the first heat exchange channel 122, such that the cool air cools the hot air.

In FIG. 5, bold arrows in the first cavity 21 illustrate the flow direction of the hot air, and bold arrows in the second cavity 22 illustrate the flow direction of the cool air. In FIG. 6, bold arrows illustrate the flow direction of the hot air. In FIG. 6, the second partition 60 is removed.

As shown in FIGS. 7 and 8, when the heat exchanger 10 is applied in the first embodiment to an electric device, the heat exchanger 10 is arranged inside the second cavity 22 of the enclosure 20. The second heat exchange channel 121 is in communication with the second cavity 22, and the first heat exchange channel 122 is in communication with the first cavity 21 of the enclosure 20 through the air vent 113. The first partition 50 is arranged inside the first cavity 21, and the inlet portion and outlet portion of the air vent 113 are located at both sides of the first partition 50 respectively, i.e. the first partition 50 separates the inlet portion from the outlet portion of the air vent 113. The first fan 30 inside the first cavity 21 faces the inlet portion of the air vent 113, and the second fan 40 inside the second cavity 22 faces the inlet of the second heat exchange channel 121. The hot air in the first cavity 21 flows through the first heat exchange channel 122 under the action of the first fan 30, and the cool air in the second cavity 22 flows through the second heat exchange channel 121 under the action of the second fan 40. The hot air and cool air exchange heat through the second heat exchange channel 121 and the first heat exchange channel 122, such that the cool air cools the hot air.

In FIG. 7, bold arrows in the first cavity 21 illustrate the flow direction of the hot air, and bold arrows in the second cavity 22 illustrate the flow direction of the cool air. In FIG. 8, bold arrows illustrate the flow direction of the cool air. In FIG. 8, the second partition 60 is removed.

### Second Embodiment

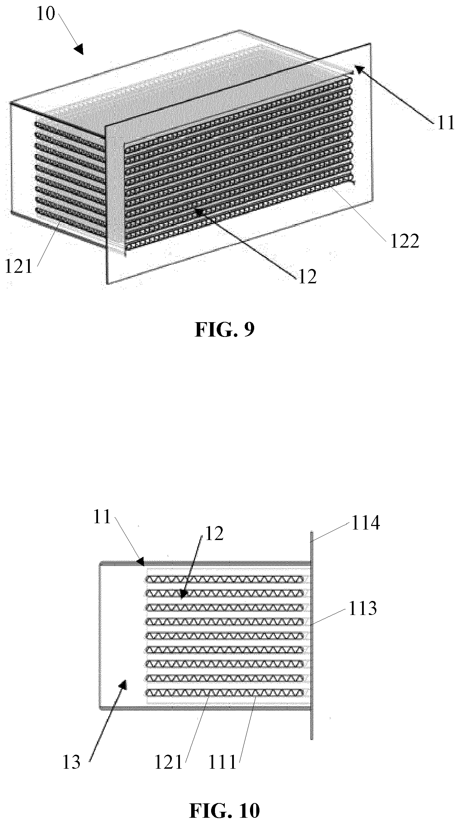

As shown in FIGS. 9 to 12, the heat exchanger 10 in the second embodiment differs from the heat exchanger 10 in the first embodiment in that, the first heat exchange channel 122 and the second heat exchange channel 121 are formed in a different manner.

In the second embodiment, the heat exchange core 12 includes one layer of the heat exchange tube 123, and the first gap is provided between at least one side of the layer of the heat exchange tubes 123. Or, the heat exchange core 12 includes at least two layers of the heat exchange tube 123, and the first gap is provided between two adjacent layers of the heat exchange tube 123.

The above first gap forms the second heat exchange channel 121. Each layer of the heat exchange tube 123 includes one heat exchange tube 123. At least two tube cavities of the heat exchange tube 123 are provided, and at least one tube cavity is the inlet channel, and at least one tube cavity is the outlet channel. Or, each layer of the heat exchange tube 123 includes at least two tubes, and in each layer of the heat exchange tube 123, the tube cavity of at least one tube is the inlet channel, and the tube cavity of at least one tube is the outlet channel.

For the type and mounting of the above heat exchange tube 123, reference is made to the first embodiment, which will not be described in the second embodiment.

To improve the heat exchange efficiency, the first gap is provided with the heat exchange member 124. The heat exchange member 124 may be a heat exchange fin or of a tube structure, which is not limited in the present embodiment.

To simplify mounting, one end of the heat exchange member 124 extends into the air inlet 111, the other end of the heat exchange member 124 extends into the air outlet 112, and the heat exchange member 124 is in a fixed connection with the housing 11. For easily fixing the heat exchange member 124 to the housing 11, the heat exchange member 124 is connected to the housing 11 by bonding or by welding.

In some cases, the heat exchange member 124 may be mounted by other means, which is not limited in the second embodiment.

For other structures of the heat exchanger 10 in the second embodiment, reference is made to the first embodiment, which will not be described in the second embodiment.

For the arrangement of the heat exchanger 10 in the second embodiment when applied to an electric device, reference is made to the first embodiment, which will not be described in the second embodiment.

### Third Embodiment

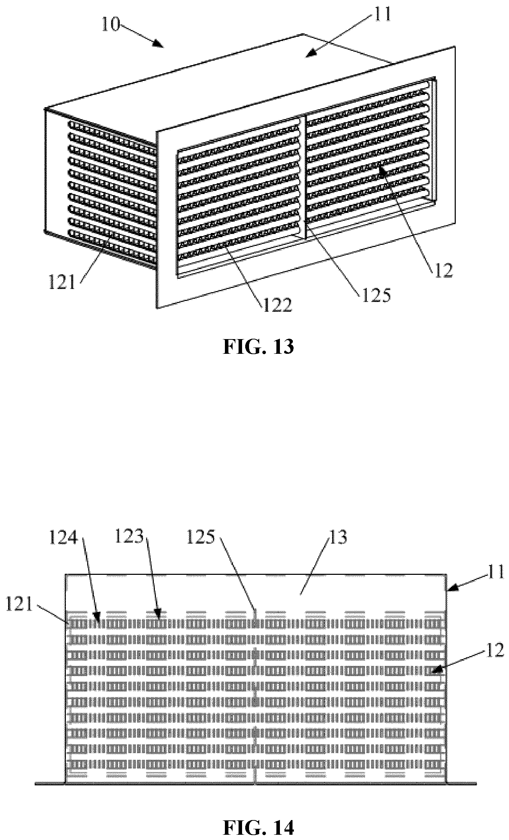

As shown in FIGS. 13 to 15, the heat exchanger 10 in the third embodiment differs from the first and second embodiment in that, the partition plate 125 is added, and the channel wall of the inlet channel of the first heat exchange channel 122 is isolated from the channel wall of the outlet channel adjacent thereto by the partition plate 125.

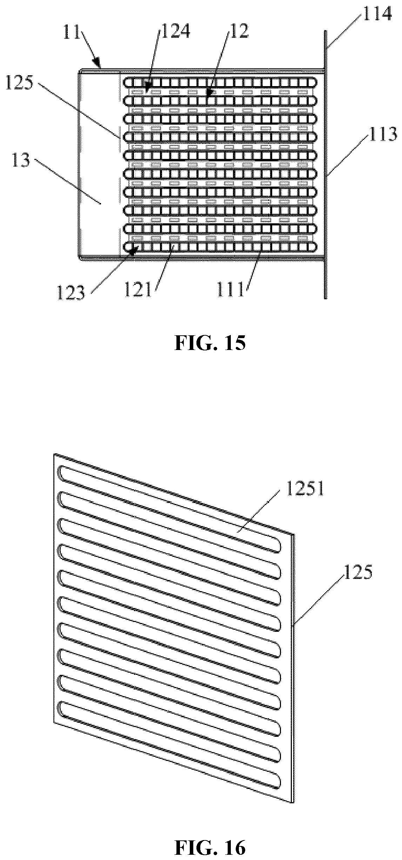

As shown in FIG. 16, if the structure of the heat exchange core 12 according to the first embodiment is applied, the partition plate 125 is provided with a mounting hole 1251 through which the heat exchange tube 123 and the heat exchange member 124 pass. If the structure of the heat exchange core 12 according to the second embodiment is applies, the partition plate 125 is provided with a mounting hole 1251 through which the heat exchange tube 123 and the heat exchange member 124 pass. It may be appreciated that, both the heat exchange tube 123 and the heat exchange member 124 are in a sealed connection with the partition plate 125.

The above partition plate 125 is in a sealed connection with the housing 11, and the partition plate 125 extends from the air vent 113 to the first communication channel 13. It should be noted that, a top end of the partition plate 125 is in a sealed connection with the top end of the housing 11, and a bottom end of the partition plate 125 is in a sealed connection with the bottom end of the housing 11. The partition plate 125 is parallel to an axis of the air vent 113 or is inclined with respect to the axis of the air vent 113. In this case, if one air vent 113 is provided, the air vent 113 is divided into two air sub-vents.

In the third embodiment, at least one inlet channel and at least one outlet channel are provided.

On one hand, at least two inlet channels are provided, where channel walls of at least two adjacent inlet channels are communicated; and/or, at least two outlet channels are provided, and the channel walls of at least two adjacent outlet channels is communicated. In this way, the turbulence effect of air is enhanced, thereby the heat exchange effect of the whole heat exchanger 10 is improved.

On the other hand, alternatively, at least two inlet channels are provided, where channel walls of any two adjacent inlet channels are isolated, i.e. channel walls of any two adjacent inlet channels are not communicated; and at least two outlet channels are provided, where channel walls of any two adjacent outlet channels are isolated, i.e. channel walls of any two adjacent outlet channels are not communicated.

To achieve the communication of the channel walls of at least two adjacent inlet channels, at least one second opening is provided between at least two adjacent inlet channels, and the second opening is in communication with the inlet channels at both sides thereof.

The above second opening is located at an end of the inlet channel close to the air vent 113, and/or at an end of the inlet channel away from the air vent 113, and/or at a middle portion of the inlet channel.

If at least two second openings are provided, any two second openings between two adjacent inlet channels are arranged one after another along the length direction of the inlet channel.

To achieve the communication of the channel walls of at least two adjacent outlet channels, at least one third opening is provided between at least two adjacent outlet channels, and the third opening communicates the outlet channels at both sides thereof.

The above third opening is located at an end of the outlet channel close to the air vent 113, and/or at an end of the outlet channel away from the air vent 113, and/or at a middle portion of the outlet channel.

If at least two third openings are provided, any two third openings between two adjacent outlet channels are arranged one after another along the length direction of the outlet channel.

The size and the shape of the second opening and the third opening are selected according to actual requirements, which is not limited in the present embodiment.

In actual situations, if three inlet channels are provided, and channel walls of only two adjacent inlet channels are communicated, there is one inlet channel, a channel wall of which is not communicated with a channel wall of the inlet channel adjacent thereto. This case is implemented by not providing openings on the channel wall of this inlet channel and nor on the channel wall of the inlet channel adjacent thereto, or by providing a baffle, through which this inlet channel is isolated from the inlet channel adjacent thereto. The above baffle may be of the same structure as the first partition 125, or may be of a different structure.

If not less than four inlet channels are provided, there are two adjacent inlet channels, the channel walls of which are not communicated. References can be made to the descriptions above, which is not described herein.

Correspondingly, if three outlet channels are provided, channel walls of only two adjacent outlet channels are communicated, and there is one outlet channel, a channel wall of which is not communicated with a channel wall of the outlet channel adjacent thereto. This case is implemented by not providing openings on the channel wall of this outlet channel and nor on the channel wall of the outlet channel adjacent thereto, or by providing a baffle, through which this outlet channel is isolated from the outlet channel adjacent thereto. The above baffle may be of the same structure as the first partition 125, or may be of a different structure.

If not less than four outlet channels are provided, there are two adjacent outlet channels, channel walls of which are not communicated. References can be made to the descriptions above, which is not described herein.

As shown in FIGS. 13 to 15, the tube cavity of the heat exchange tube 123 is the second heat exchange channel 121, the heat exchange member 124 is arranged in the first gap, and the heat exchange member 124 divides the first gap into the inlet channel and the outlet channel.

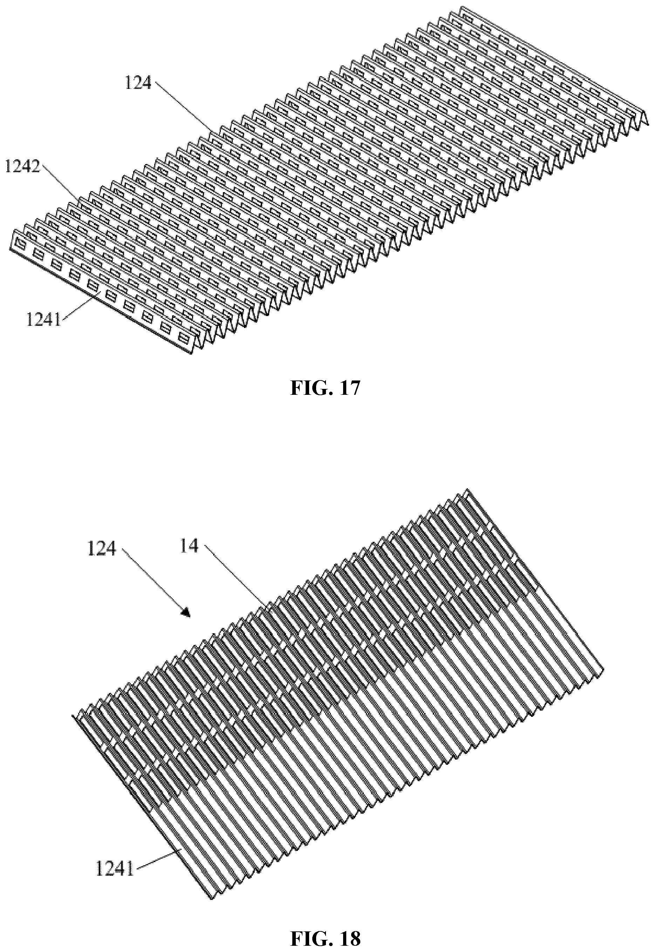

As shown in FIG. 17, the above heat exchange member 124 is a heat exchange fin. The heat exchange fin includes multiple inclined plates 1241 that are connected one after another, and there is an angle between two adjacent inclined plates. In the two adjacent inclined plates 1241, an end portion of one inclined plate 1241 is connected to an end of the other inclined plate 1241, and the sub-channel is formed between two adjacent inclined plates 1241. To simplify the processing and mounting of the heat exchange fin, each inclined plate 1241 is provided with at least one first through hole 1242. A first through hole 1242 on the inclined plate 1241 forming the inlet channel is the second opening, and a first through hole 1242 on the inclined plate 1241 forming the outlet channel is the third opening.

To simplify the manufacturing, in the above heat exchange fin, any two first through holes 1242 are of the same shape and size, and the first through hole 1242 on each inclined plate 1241 is of the same number.

In actual situations, alternatively, several inclined plates 1241 forming the inlet channel are provided with the first through hole 1242, and/or several inclined plates 1241 forming the outlet channel are provided with the first through hole 1242, which is not limited to the structure shown in FIG. 17.

In the above heat exchange fins, for simply mounting, bottom ends of any two inclined plates 1241 are at the same level, and top ends of any two inclined plates 1241 are at the same level.

It should be noted that, alternatively, the third embodiment applies the structure of the heat exchange core 12 in the second embodiment. Specifically, each layer of the heat exchange tubes 123 includes one heat exchange tube 123, and at least two tube cavities of the heat exchange tubes 123 are provided, and at least one tube cavity is the inlet channel, and at least one tube cavity is the outlet channel. In this case, the heat exchange tube 123 includes a tube body and a separator arranged inside the tube body, and the separator divides an inner cavity of the tube body into at least two tube cavities, and each separator is provided with at least one second through hole. A second through hole on the separator forming the inlet channel is the second opening, and a second through hole on the separator forming the outlet channel is the third opening.

To simplify the manufacturing, in the above heat exchange tube 123, any two second through holes are of the same shape and size, and the second through hole on each separator is of the same number.

In actual situations, alternatively, several separators forming the inlet channel are provided with the second through hole, and/or several separators forming the outlet channel are provided with the second through hole, which is not limited to the above structure.

Alternatively, each layer of the heat exchange tube 123 includes at least two tubes, and tube cavities of all tubes of each layer of the heat exchange tube 123 form the first heat exchange channel 122, i.e. in each layer of the tubes, at least one tube forms the inlet channel, and at least one tube forms the outlet channel. In this case, each heat exchange tube 123 is provided with at least one second through hole. A second through hole on the heat exchange tube 123 forming the inlet channel is the second opening, and a second through hole on the heat exchange tube 123 forming the outlet channel is the third opening.

To simplify the manufacturing, second through holes in any two above tubes are of the same shape and size.

In actual situations, alternatively, the at least one tube forming the inlet channel is provided with the second through hole, and/or the at least one heat exchange tube forming the outlet channel is provided with the second through hole, which is not limited to the above structure.

For other structures of the heat exchanger 10 in the third embodiment, references are made to the first and second embodiments, which will not be described in the present embodiment.

When the heat exchanger 10 in the third embodiment is applied in an electric device, for the arrangement of the heat exchanger 10, reference is made to the first embodiment, which is not described in the third embodiment.

### Fourth Embodiment

The heat exchanger 10 in the fourth embodiment differs from the heat exchanger 10 in the first embodiment in that, the second communication channel is added.

In the fourth embodiment, the heat exchanger 10 further includes the second communication channel, which is arranged in the heat exchange core 12. The second communication channel is located at the end of the heat exchange core 12 away from the air vent 113, and the communication direction of the first communication channel 13 is the same as the communication direction of the second communication channel. In this way, one part of the air flowing through the first heat exchange channel 122 can flow through the first communication channel 13, while the other part thereof can flow through the second communication channel. Since the second communication channel is arranged in the heat exchange core 12, the heat exchange path is lengthened, and the heat exchange effect is enhanced.

In a case that the first heat exchange channel 122 includes the inlet channel and the outlet channel, one part of the air flowing out of the inlet channel flows into the outlet channel via the first communication channel 13, and the other part thereof flows into the outlet channel via the second communication channel.

The above inlet channel and the outlet channel are both sub-channels. In the first heat exchange channel 122, at least one first opening 14 is provided between two adjacent sub-channels. The first opening 14 is located at the end of the sub-channel away from the air vent 113, and the first opening 14 is in communication with the sub-channels at both sides thereof to form the second communication channel.

As shown in FIG. 18, in a case that the heat exchange member 124 is provided in the first gap to form a portion of the first heat exchange channel 122 apart from the first communication channel 13, the first opening 14 is arranged on the heat exchange member 124. Specifically, the above heat exchange member 124 is a heat exchange fin. The heat exchange fin includes multiple inclined plates 1241 that are connected one after another, and there is an angle between two adjacent inclined plates. In two adjacent inclined plates 1241, an end portion of one inclined plate 1241 is connected to an end of the other inclined plate 1241, and the sub-channel is formed between two adjacent inclined plates 1241. The first opening 14 is arranged at an end of each inclined plate 1241 away from the air vent 113.

For other structures of the heat exchanger 10 in the fourth embodiment, reference can be made to the first embodiment, which is not described in the fourth embodiment.

When the heat exchanger 10 in the fourth embodiment is applied to an electric device, for the arrangement of the heat exchanger 10, reference can be made to the first embodiment, which is not described in the present embodiment.

### Fifth Embodiment

The heat exchanger 10 in the fifth embodiment differs from the heat exchanger 10 in the second embodiment in that, the second communication channel is added.

For the functions and formation of the second communication channel, reference is made to the fourth embodiment, which is not described in the present embodiment.

Each layer of the heat exchange tube 123 includes one tube. At least two tube cavities of the tube are provided, and at least one tube cavity is the inlet channel, and at least one tube cavity is the outlet channel. In this case, the first opening 14 is arranged in the tube.

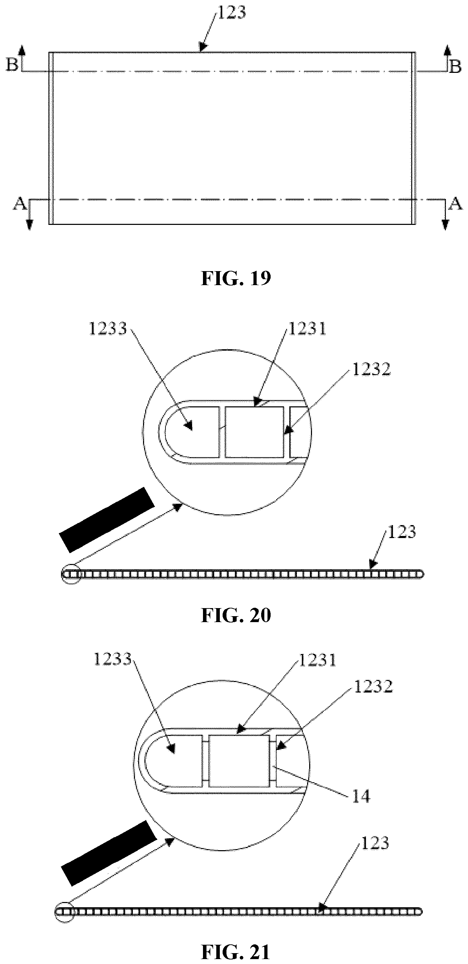

As shown in FIGS. 19 to 22, the tube includes at least two tube cavities 1233, and at least one tube cavity 1233 is the inlet channel, and at least one tube cavity 1233 is the outlet channel. It may be appreciated that, the tube includes the tube body 1231 and the separator 1232 arranged inside the tube body 1231, and the separator 1232 divides the inner cavity of the tube body 1231 into at least two tube cavities 1233. An end of the heat exchange tube 123 away from the air vent 113 is provided with at least one first opening 14 to form the second communication channel, and the first opening 14 is arranged on the separator 1232.

In some cases, the heat exchange tube 123 is of a cuboid-like shape, and a width direction of the heat exchange tube 123 is the direction along which the inlet channel and the outlet channel are arranged one after another, and a length direction of the heat exchange tube 123 is the length direction of the inlet channel and the outlet channel. In the length direction of the heat exchange tube 123, a length of the separator 1232 is smaller than a length of the heat exchange tube 123, such that a portion, where the separator 1232 is not provided, of the heat exchange tube 123 in the length direction thereof is formed with the above first opening 14.

In other cases, each layer of the heat exchange tube includes at least two tubes, where the tube cavity of at least one tube is the inlet channel, and the tube cavity of at least one tube is the outlet channel. The above first opening 14 is arranged on a tube wall of the heat exchange tube 123. It may be appreciated that, the first opening 14 is located at the end of the heat exchange tube 123 away from the air vent 113.

For other structures of the heat exchanger 10 in the fifth embodiment, reference is made to the second embodiment, which is not described in the present embodiment.

When the heat exchanger 10 in the fifth embodiment is applied to an electric device, for the arrangement of the heat exchanger 10, reference can be made to the first embodiment, which is not described in the fifth embodiment.

### Sixth Embodiment

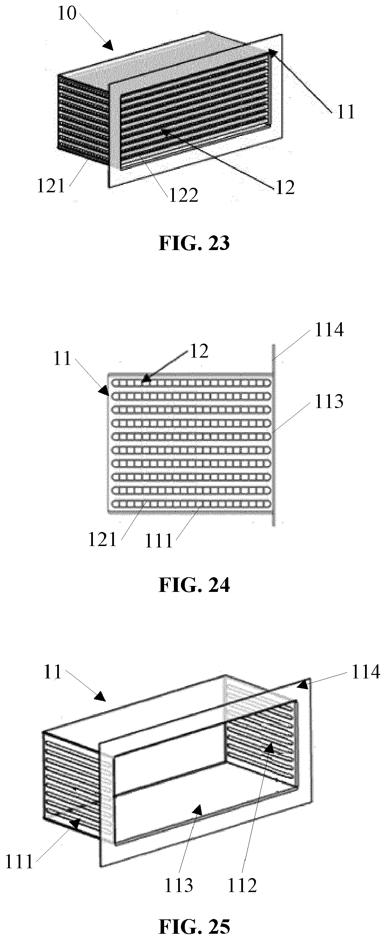

As shown in FIGS. 23 to 26, the heat exchanger 10 in the sixth embodiment differs from the heat exchanger 10 in the first embodiment in that, the first heat exchange channel 122 does not include the first communication channel 13, and the first heat exchange channel 122 includes the second communication channel.

In the sixth embodiment, the heat exchanger 10 includes the second communication channel, the first heat exchange channel 122 and the second heat exchange channel 121, and the second communication channel is arranged in the heat exchange core 12, and the second communication channel is located at the end of the heat exchange core 12 away from the air vent 113. In this way, the air flowing through the first heat exchange channel 122 flows through the second communication channel. Since the second communication channel is arranged in the heat exchange core 12, the heat exchange path is lengthened, and the heat exchange effect is enhanced.

In the sixth embodiment, the heat exchange core 12 extends to the end in the housing 11 away from the air vent 113, and the end of the heat exchange core 12 away from the air vent 113 is in a sealed connection with the end in the housing 11 away from the air vent 113. In this case, the end in the housing 11 away from the air vent 113 is taken as the bottom end, the air inlet 111 and the air outlet 112 extends to the bottom end of the housing 11, so as to enlarge the heat exchange core 12, thereby improving the heat exchange efficiency.

In the case that the first heat exchange channel 122 includes the inlet channel and the outlet channel, the air flowing out of the inlet channel flows into the outlet channel via the second communication channel.

The above inlet channel and outlet channel are both sub-channels. In the first heat exchange channel 122, at least one first opening 14 is arranged between two adjacent sub-channels. The first opening 14 is located at the end of the sub-channel away from the air vent 113, and communicates the sub-channels on both sides thereof to form the second communication channel.

In the case that the heat exchange member 124 is provided in the first gap to form the first heat exchange channel 122, the first opening 14 is arranged on the heat exchange member 124. The sixth embodiment has the heat exchange member 124 shown in FIG. 18, and reference can be made to the fourth embodiment, which is not described in the present embodiment.

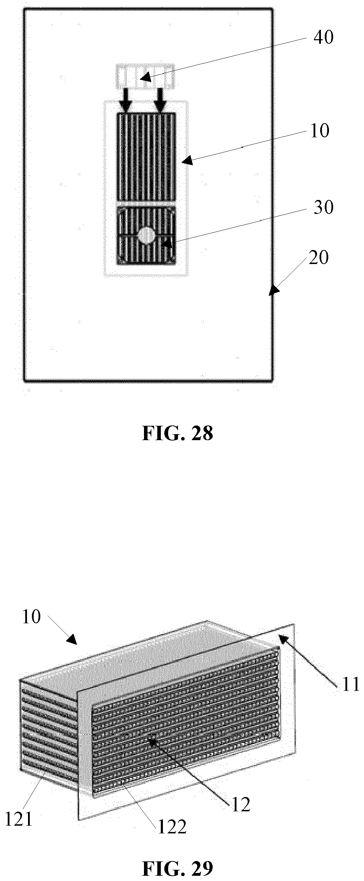

The heat exchanger 10 in the sixth embodiment is applied to an electric device. As shown in FIGS. 27 and 28, the heat exchanger 10 is arranged inside the second cavity 22 of the enclosure 20 of the electric device. The second heat exchange channel 121 of the heat exchanger 10 is in communication with the second cavity 22, and the first heat exchange channel 122 of the heat exchanger 10 is in communication with the first cavity 21 via the air vent 133. The first fan 30 is arranged at the inlet of the air vent 113, and the second fan 40 is arranged at the inlet of the second heat exchange channel 121. The hot air in the first cavity 21 flows through the first heat exchange channel 122 under the action of the first fan 30, and the cool air in the second cavity 22 flows through the second heat exchange channel 121 under the action of the second fan 40. The hot air and cool air exchange heat through the second heat exchange channel 121 and the first heat exchange channel 122, such that the cool air cools the hot air.

In FIG. 27, bold arrows in the first cavity 21 illustrate the flow direction of the hot air, and bold arrows in the second cavity 22 illustrate the flow direction of the cool air. In FIG. 28, bold arrows illustrate the flow direction of the cool air. In FIG. 28, the second partition 60 is removed.

In actual situations, the first partition 50 is provided in the first cavity 21, and the first partition 50 separates the inlet of the inlet channel from the outlet of the outlet channel, with reference to the first embodiment, which will not be described in the present embodiment.

In actual situations, alternatively, the heat exchanger 10 is arranged inside the first cavity 21 of the enclosure 20. Reference can be specifically made to the first embodiment, which is not described in the present embodiment.

### Seventh Embodiment

As shown in FIGS. 29 to 32, the heat exchanger 10 in the seventh embodiment differs from the heat exchanger 10 in the sixth embodiment in that, the second communication channel is formed in a different manner.

In the seventh embodiment, the heat exchange core 12 includes one layer of the heat exchange tube 123, and the first gap is provided between at least one side of the layer of the heat exchange tube 123 and the housing 11. Or, the heat exchange core 12 includes at least two layers of the heat exchange tube 123, and the first gap is provided between two adjacent layers of the heat exchange tube 123. The first gap is the second heat exchange channel 121.

Each layer of the heat exchange tube 123 includes one tube. At least two tube cavities of the heat exchange tube 123 are provided, and at least one tube cavity is the inlet channel, and at least one tube cavity is the outlet channel. The first opening 14 is arranged in the heat exchange tube 123 to form the second communication channel. For the specific structure of the heat exchange tube 123, references can be made to the FIGS. 19 to 22 of the fifth embodiment, which is not described here.

In actual situations, alternatively, each layer of the heat exchange tube 123 includes at least two tubes, and the tube cavity of at least one tube is the inlet channel, and the tube cavity of at least one tube is the outlet channel. The first opening 14 is provided on the tube wall of the tube. It may be appreciated that, the first opening 14 is located at the end of the tube away from the air vent 113.

In the seventh embodiment, in order to improve the heat exchange efficiency, the heat exchange member 124 is provided in the first gap. The heat exchange member 124 is a heat exchange fin or a second heat exchange tube, which can be selected according to actual situations, and is not limited in the present embodiment.

For simply mounting, one end of the heat exchange member 124 extends into the air inlet 111, the other end of the heat exchange member 124 extends into the air outlet 112, and the heat exchange member 124 is in a fixed connection with the housing 11. To facilitate the fixed connection between the heat exchange member 124 and housing 11, the heat exchange member 124 is connected to the housing 11 by bonding or by welding.

In some cases, the heat exchange member 124 may be mounted by other means, which is not limited in the seventh embodiment.

The heat exchanger 10 in the seventh embodiment is applied to an electric device. For the arrangement of the heat exchanger 10 inside the enclosure 20 of the electric device, reference is made to the sixth embodiment, which will not be described here.

It is known from the above first, second, fourth, fifth, sixth and seventh embodiments, the positions of the heat exchange channel 124 and the heat exchange tube 123 can exchange, such that the heat exchange core 12 is applicable to different situations, thereby improving the flexibility of use.

In the above seven embodiments, the heat exchange core 12 includes the heat exchange tube 123 and the heat exchange member 124. The heat exchange tube 123 and the heat exchange member 124 can be obtained by machining, i.e. the heat exchange tube 123 and the heat exchange member 124 are machined parts, and the housing 11 may be a machined part as well. In this way, the whole heat exchanger 10 can be easily processed, and the cost for processing is reduced.

Based on the above description of the disclosed embodiments, those skilled in the art are capable of carrying out or using the present application. It is obvious for those skilled in the art to make many modifications to these embodiments. The general principle defined herein may be applied to other embodiments without departing from the spirit or scope of the present application. Therefore, the present application is not limited to the embodiments illustrated herein, but should be defined by the broadest scope consistent with the principle and novel features disclosed herein.

## Claims

1. A heat exchanger, comprising a housing, and a heat exchange core arranged inside the housing, wherein
a side of the housing is provided with an air vent, the heat exchanger is provided with a communication channel in communication with the air vent; and
the communication channel is located inside the housing, and the communication channel is located at a side in the housing opposite to the air vent.

2. The heat exchanger according to claim 1, wherein the communication channel comprises a first communication channel, and a gap is provided between an end of the heat exchange core away from the air vent and the housing, and the gap forms the first communication channel.

3. The heat exchanger according to claim 2, wherein
the heat exchanger further comprises a first heat exchange channel located inside the housing, and the first heat exchange channel comprises at least one inlet channel and at least one outlet channel, both of which are arranged in the heat exchange core; and
an inlet of the inlet channel and an outlet of the outlet channel are both in communication with the air vent, and the first communication channel is in communication with an outlet of the inlet channel and an inlet of the outlet channel.

4. The heat exchanger according to claim 3, wherein in the first heat exchange channel, a channel wall of the inlet channel is isolated from a channel wall of the outlet channel adjacent the inlet channel.

5. The heat exchanger according to claim 4, wherein
at least two inlet channels are provided, and at least one second opening is provided between at least two adjacent inlet channels, and the second opening is in communication with the inlet channels at both sides of the second opening;
and/or, at least two outlet channels are provided, and at least one third opening is provided between at least two adjacent outlet channels, and the third opening is in communication with the outlet channels at both sides of the third opening.

6. The heat exchanger according to claim 4, wherein in the first heat exchange channel, the inlet channel is isolated from the outlet channel adjacent the inlet channel by a partition plate, and the partition plate is in a sealed connection with the housing, and the partition plate extends from the air vent to the first communication channel.

7. The heat exchanger according to claim 4, wherein
at least two inlet channels are provided, and channel walls of any two adjacent inlet channels are isolated; and
at least two outlet channels are provided, and channel walls of any two adjacent outlet channels are isolated.

8. The heat exchanger according to claim 3, wherein
the communication channel further comprises a second communication channel;
the inlet channel and the outlet channel are both sub-channels;
in the first heat exchange channel, at least one first opening is provided between two adjacent sub-channels, the first opening is located at an end of the sub-channel away from the air vent, and the first opening is in communication with the sub-channels at both sides of the first opening to form the second communication channel.

9. The heat exchanger according to claim 2, wherein
the communication channel further comprises a second communication channel, and the second communication channel is arranged in the heat exchange core; and
a communication direction of the first communication channel is the same as a communication direction of the second communication channel.

10. The heat exchanger according to claim 1, wherein
the communication channel further comprises a second communication channel; and
the second communication channel is arranged in the heat exchange core, and the end of the heat exchange core away from the air vent is in a sealed connection with the housing.

11. The heat exchanger according to claim 10, wherein
the heat exchanger further comprises a first heat exchange channel located inside the housing;
the first heat exchange channel comprises an inlet channel and an outlet channel, and an inlet of the inlet channel and an outlet of the outlet channel are both in communication with the air vent;
the second communication channel is in communication with an outlet of the inlet channel and an inlet of the outlet channel;
the inlet channel and the outlet channel are both sub-channels; and
in the first heat exchange channel, at least one first opening is provided between two adjacent sub-channels, and the first opening is located at the end of the sub-channel away from the air vent, and the first opening is in communication with the sub-channels at both sides of the first opening to form the second communication channel.

12. The heat exchanger according to claim 3 or 11, wherein
the inlet of the inlet channel and the outlet of the outlet channel are arranged one after another along a width direction or a length direction of the air vent;
and/or, the inlet channel and the outlet channel are both straight channels.

13. The heat exchanger according to any of claims 3 to 8 and 11, wherein
the heat exchanger further comprises a second heat exchange channel, which is configured to exchange heat with the first heat exchange channel; and
the housing is provided with an air inlet and an air outlet, and the air inlet, the second heat exchange channel and the air outlet are communicated one after another.

14. The heat exchanger according to claim 13, wherein the air inlet and the air outlet are located at two opposite sides of the housing, and the air inlet and the air outlet are located at a same side of the air vent.

15. The heat exchanger according to claim 13, wherein
the heat exchange core comprises one layer of heat exchange tube, and a first gap is provided between at least one side of the one layer of the heat exchange tube and the housing;
or the heat exchange core comprises at least two layers of the heat exchange tube, and the first gap is provided between two adjacent layers of the heat exchange tube; and
each layer of the heat exchange tube comprises at least one tube, a tube cavity of the tube is the second heat exchange channel, and a heat exchange member is arranged in the first gap to form the inlet channel and the outlet channel,
wherein an end of the heat exchange tube extends into the air inlet, the other end of the heat exchange tube extends into the air outlet, and the heat exchange tube is in a fixed connection with the housing.

16. The heat exchanger according to claim 13, wherein
the heat exchange core comprises one layer of heat exchange tube, and the first gap is provided between at least one side of the one layer of the heat exchange tube and the housing;
or the heat exchange core comprises at least two layers of the heat exchange tube, and the first gap is provided between two adjacent layers of the heat exchange tube; wherein
the first gap is the second heat exchange channel; and
each layer of the heat exchange tube comprises one heat exchange tube, and at least two tube cavities of the heat exchange tube are provided to form the inlet channel and the outlet channel;
or each layer of the heat exchange tube comprises at least two tubes, and in each layer of the heat exchange tube, a tube cavity of at least one tube forms the inlet channel, and a tube cavity of at least one heat exchange tube forms the outlet channel,
wherein a heat exchange member is arranged in the first gap, an end of the heat exchange member extends into the air inlet, the other end of the heat exchange member extends into the air outlet, and the heat exchange member is in a fixed connection with the housing.

17. The heat exchanger according to claim 1, wherein
the housing is an one-piece structure;
and/or, a flange structure is arranged on the housing at a periphery of the air vent, and the flange structure is in a sealed connection with a cavity of an electric device.

18. An electric device, comprising an enclosure, and at least one heat exchanger according to any one of claims 1 to 17, wherein
the enclosure comprises a first cavity and a second cavity, a heat generating device is arranged inside the first cavity, and the first cavity is a sealed cavity;
the heat exchanger is arranged inside the first cavity, and the air vent of the heat exchanger is in communication with the second cavity;
or, the heat exchanger is arranged inside the second cavity, and the air vent of the heat exchanger is in communication with the first cavity.

19. The electric device according to claim 18, comprising:
a first partition, the first partition is arranged in the first cavity or the second cavity which is in communication with the air vent, and the first partition is located at the air vent, and separates an inlet portion and an outlet portion of the air vent apart; and
and/or a second partition, the second partition is arranged inside the enclosure, and the second partition divides an inner cavity of the enclosure into the first cavity and the second cavity,
and/or at least one first fan, and/or at least one second fan, wherein the first fan is configured to drive airflow in the first cavity, and the second fan is configured to drive airflow in the second cavity.
